# EUROPÄISCHE PATENTSCHRIFT

(11) **EP 0 998 179 B1**
(45) Veröffentlichungstag und Bekanntmachung des Hinweises auf die Patenterteilung: **16.01.2002**
(21) Anmeldenummer: 99119591.8
(22) Anmeldetag: 02.10.1999
(51) Int. Cl.: H05K 7/14

(54) **Einrichtung zum Abstützen einer Schaltungsplatine**
Device to support a circuit board
Support pour une plaquette à circuit imprimé

(30) Priorität: 15.10.1998 DE 19847521
(43) Veröffentlichungstag der Anmeldung: 03.05.2000
(73) Patentinhaber: Diehl Stiftung & Co., 90478 Nürnberg (DE)
(72) Erfinder: Fürst, Wilhelm, 92369 Sengenthal (DE); Kratz, Bernhard, 90530 Wendelstein (DE)

(56) Entgegenhaltungen:
- DE-A- 4 112 831

## Beschreibung

Die Erfindung betrifft eine Einrichtung zum Abstützen einer Funktionsbauelemente aufweisenden Schaltungsplatine gemäß dem Oberbegriff des Anspruchs 1.

Aus der DE 34 01 513 C2 ist ein Geschoß bekannt, bei dem eine elektronische Zündschaltung in einem Zündergehäuse untergebracht ist, das am Geschoßmantel befestigt ist. Dort ist die Zündschaltung in einen Kunststoff-Hartschaumblock eingeschäumt. In das Zündergehäuse sind flächige elastische Dämpfungskörper eingelegt, die den Hartschaumblock gemeinsam allseitig umschließen.

Nachteilig beim Einschäumen ist, daß die Beweglichkeit von Funktionsbauteilen beeinträchtigt werden kann, die beweglich sein müssen. Ungünstig ist auch, daß beim Aufschäumen mechanische Spannungen zwischen den Funktionsbauteilen und der Schaltungsplatine entstehen können, die möglicherweise zu einem Abreißen der elektrischen Verbindung zwischen den Funktionsbauteilen und der Schaltungsplatine führen können. Ähnliche Nachteile treten auf, wenn die Schaltungsplatine und die Funktionsbauteile bzw. -elemente in einen Block eingegossen werden.

Um diese Mängel zu beseitigen, offenbart die DE 41 12 831 A1 eine Einrichtung zum Abstützen von auf einer Schaltungsplatine angeordneten Funktionsbauteilen bzw. - elementen in einem Trägerkörper, insbes. bei einem Geschoß, wobei die Schaltungsplatine und die Funktionsbauteile innerhalb einer Aussparung des Trägerkörpers liegen. In die Aussparung ist ein aus einem kompressiblen Kunststoff vorgefertigtes Formteil eingesetzt, dessen Profil den Funktionsbauteilen etwa angepaßt ist. Das Formteil wird durch eine Abdeckung der Öffnung der Aussparung gegen die Wände der Aussparung gequetscht, so daß die Funktionsbauteile gegen die Schaltungsplatine gehalten werden. Bei dieser bekannten Abstützeinrichtung ergeben sich Kraftkomponenten in radialer Richtung, was bei den extrem großen Beschleunigungskräften, die bei einem Geschoß auftreten, zu erheblichen Problemen bezüglich der Funktionssicherheit der Schaltungsplatine bzw. der an ihr vorgesehenen Funktionsbauelemente führen kann.

In Kenntnis dieser Gegebenheiten liegt der vorliegenden Erfindung die Aufgabe zugrunde, eine Einrichtung der eingangs genannten Art zur funktionssicheren Halterung der Funktionsbauelemente bei den auftretenden, extrem hohen Beschleunigungskräften eines Geschosses zu gewährleisten.

Diese Aufgabe wird bei einer Einrichtung der eingangs genannten Art erfindungsgemäß durch die Merkmale des Kennzeichenteiles des Anspruchs 1 gelöst. Bevorzugte Aus- bzw. Weiterbildungen der erfindungsgemäßen Einrichtung sind in den Unteransprüchen gekennzeichnet.

Es hat sich überraschenderweise gezeigt, daß durch die erfindungsgemäße Ausbildung derart, daß die Schaltungsplatine aus einem kohlefaserverstärkten Kunststoff besteht, wobei zwischen der Schaltungsplatine und dem Träger eine elastische Dämpfungslage vorgesehenist, und daß die Schaltungsplatine und die Dämpfungslage mit ihren Umfangsrändern von der Innenwand des Geschosses beabstandet sind, verhindert wird, daß sich in radialer Richtung große Kraftkomponenten aufbauen, so daß beschleunigungsbedingte Beschädigungen der Schaltungsplatine bzw. der an ihr vorgesehenen Funktionsbauelemente auf einfache Weise vermieden werden. Diese vorteilhafte Eigenschaft kann erfindungsgemäß noch dadurch unterstützt werden, daß der Träger eine Metallplatte aufweist, die im Gehäuse, deren Querschnitt überbrückend, befestigt ist. Die Träger-Metallplatte ist erfindungsgemäß vorzugsweise mit einem Durchgangsloch ausgebildet.

Die zwischen der Schaltungsplatine und der Träger-Metallplatte vorgesehene elastische Dämpfungslage und insbes. die Träger-Metallplatte dienen zur Aufnahme der axialen Kraftkomponente der Beschleunigungskräfte. Die Betriebszuverlässigkeit der Schaltungsplatine wird erfindungsgemäß im Vergleich zu bekannten Einrichtungen der gattungsgemäßen Art dadurch verbessert, daß sie aus einem kohlefaserverstärkten Kunststoff besteht.

Als besonders zweckmäßig hat es sich erwiesen, wenn die Träger-Metallplatte eine Dicke besitzt, die mehrfach größere ist als die Dicke der Schaltungsplatine und der elastischen Dämpfungslage. Die Dämpfungslage und die Schaltungsplatine können hierbei aneinander mindestens annähernd angepaßte Dicken besitzen. Selbstverständlich ist es auch möglich, daß die Dämpfungslage und die Schaltungsplatine voneinander verschiedene Dicken besitzen, bzw. daß die Dämpfungslage dicker ist als die Schaltungsplatine.

Um radiale Kraftkomponenten nicht nur durch die Ausbildung der Träger-Metallplatte mit einem Durchgangsloch, das vorzugsweise in einem mittleren Bereich der Träger-Metallplatte ausgebildet ist, zu eliminieren, ist es zweckmäßig, wenn auch die Schaltungsplatine und die Dämpfungslage mit Löchern ausgebildet sind. Diese zuletzt genannten Löcher können sich mit dem Durchgangsloch der Träger-Metallplatte überdecken. Dabei können die Löcher in der Schaltungsplatine und in der Dämpfungslage und das Durchgangsloch in der Träger-Metallplatte mindestens annähernd deckungsgleich ausgebildet sein. Durch eine solche Ausbildung der oben beschriebenen Art werden radiale Kraftkomponenten, die aus der extrem hohen Beschleunigungskraft eines Geschosses resultieren, zuverlässig vermieden, so daß Beschädigungen der Schaltungsplatine bzw. der an ihr befindlichen Funktionsbauelemente zuverlässig auszuschließen sind.

Die Träger-Metallplatte der erfindungsgemäßen Abstützeinrichtung kann an einer radial in das Geschoß hineinragenden Konsole befestigt sein. Diese Konsole kann als im Inneren des Geschosses umlaufender Bund oder Kragen gestaltet sein.

Zweckmäßigerweise ist die Träger-Metallplatte mit der besagten Konsole in axialer Richtung des Geschosses verschraubt. Auf diese Weise ergibt sich der Vorteil einer einfachen Montierbarkeit.

Zweckmäßigerweise ist die Konsole mit einer an die Dicke der Träger-Metallplatte angepaßten axialen Abmessung dimensioniert, um die mechanische Festigkeit in axialer Richtung entsprechend zu optimieren.

Bei der erfindungsgemäßen Abstützeinrichtung hat es sich als vorteilhaft erwiesen, wenn die Dämpfungslage aus einem zelligen Polyurethan-Elastomer (PUR) besteht. Ein solches Polyurethan-Elastomer ist bspw. in einem Firmenprospekt der Elastogran Kunststoff-Technik GmbH, Lemförde, "Elastogran Kunststoff-Technik, EKT 0029-3-79 oder 0027-6-81/1" beschrieben.

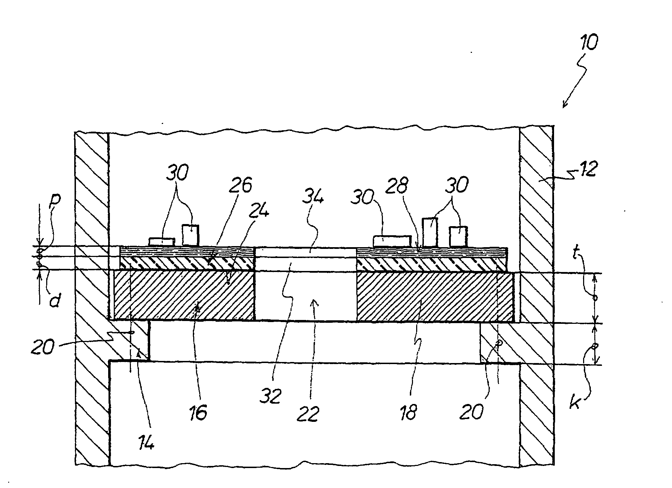

Weitere Einzelheiten, Merkmale und Vorteile ergeben sich aus der nachfolgenden Beschreibung eines in der Zeichnung schematisch in einer Schnittdarstellung gezeichneten Ausführungsbeispieles eines abschnittweise gezeichneten Geschosses mit einer erfindungsgemäßen Abstützeinrichtung.

Die Figur zeigt abschnittweise längsgeschnitten ein Geschoß 10, von dessen Geschoß-Wandung 12 einstückig radial nach innen eine umlaufende Konsole 14 wegsteht. An der Konsole 14 ist ein Träger 16 festgeschraubt, der von einer Metallplatte 18 gebildet ist. Die Verschraubung der Träger-Metallplatte 18 mit der im Inneren des Geschosses 10 umlaufenden Konsole 14 ist durch dünne strichpunktierte Linien 20 schematisch verdeutlicht, welche die Mittellinien entsprechender Gewindeschrauben darstellen.

Die Träger-Metallplatte 18 ist in einem mittleren Bereich mit einem Durchgangsloch 22 ausgebildet.

An der von der Konsole 14 abgewandten Hauptfläche 24 der Träger-Metallplatte 18 ist eine elastische Dämpfungslage 26 angebracht. Auf der Dämpfungslage 26 ist eine Schaltungsplatine 28 angeordnet, die elektrische bzw. elektronische Funktionsbauelemente 30 aufweist. Die Dämpfungslage 26 besteht vorzugsweise aus einem zelligen Polyurethan-Elastomer (PUR) und die Schaltungsplatine 28 besteht vorzugsweise aus einem kohlefaserverstärkten Kunststoff. Die Dämpfungslage 26 und die Schaltungsplatine 28 sind mit Löchern 32 und 34 ausgebildet, die mit dem Durchgangsloch 22 in der Träger-Metallplatte 18 deckungsgleich ausgebildet sind. Die Dämpfungslage 26, die Schaltungsplatine 28 und die Träger-Metallplatte 18 sind mit ihren Umfangsrändern von der Innenwand des Gehäuses beabstandet, so daß Kraftkomponenten in radialer Richtung zwischen dem Gehäuse des Geschosses 10 und der Schaltungsplatine 28 vermieden werden.

Die im Inneren des Geschosses 10 umlaufende Konsole 14 weist eine Dicke k auf und die Träger-Metallplatte 18 weist eine Dicke t auf. Die Dicken k und t sind zweckmäßigerweise mindestens annähernd gleich groß. Die Dämpfungslage 26 weist eine Dicke d und die Schaltungsplatine 28 weist eine Dicke p auf. Die Dicken d und p können aneinander angepaßt, d.h. mindestens annähernd gleich dick sein, es ist jedoch bspw. auch möglich, daß die Dicke d der elastischen Dämpfungslage 26 größer ist als die Dicke p der Schaltungsplatine 28.

## Patentansprüche

1. Einrichtung zum Abstützen einer Funktionsbauelemente (30) aufweisenden Schaltungsplatine (28) an einem Träger (16) eines Geschosses (10),
**dadurch gekennzeichnet ,**
**daß** der Träger (16) eine Metallplatte (18) aufweist, die im Geschoß (10), deren Querschnitt überbrückend, befestigt ist, daß die Schaltungsplatine (28) aus einem kohlefaserverstärkten Kunststoff besteht, wobei zwischen der Schaltungsplatine (28) und dem Träger (16) eine elastische Dämpfungslage (26) vorgesehen ist, und daß die Schaltungsplatine (28) und die Dämpfungslage (26) mit ihren Umfangsrändern von der Innenwand des Geschosses (10) beabstandet sind.

2. Einrichtung nach Anspruch 1,
**dadurch gekennzeichnet,**
**daß** die Träger-Metallplatte (18) mit einem Durchgangsloch (22) ausgebildet ist.

3. Einrichtung nach Anspruch 1 oder 2,,
**dadurch gekennzeichnet ,**
**daß** die Träger-Metallplatte (18) eine Dicke (t) besitzt, die mehrfach größer ist als die Dicke (p und d) der Schaltungsplatine (28) und der Dämpfungslage (26).

4. Einrichtung nach Anspruch 3,
**dadurch gekennzeichnet ,**
**daß** die Dämpfungslage (26) und die Schaltungsplatine (28) aneinander mindestens annähernd angepaßte Dicken (d, p) besitzen.

5. Einrichtung nach Anspruch 3 oder 4,
**dadurch gekennzeichnet ,**
**daß** die Schaltungsplatine (28) und die Dämpfungslage (26) mit Löchern (34, 32) ausgebildet sind, die sich mit dem Durchgangsloch (22) der Träger-Metallplatte (18) überdecken.

6. Einrichtung nach Anspruch 5,
**dadurch gekennzeichnet,**
**daß** die Löcher (34, 32) in der Schaltungsplatine (28) und in der Dämpfungslage (26) und das Durchgangsloch (22) in der Träger-Metallplatte (18) mindestens annähend deckungsgleich ausgebildet sind.

7. Einrichtung nach einem der Ansprüche 1 bis 5,
**dadurch gekennzeichnet ,**
**daß** die Träger-Metallplatte (18) an einer radial in das Geschoß (10) hineinragenden Konsole (14) befestigt ist.

8. Einrichtung nach Anspruch 7,
**dadurch gekennzeichnet ,**
**daß** die Träger-Metallplatte (18) mit der Konsole (14) in axialer Richtung des Geschosses (10) verschraubt ist.

9. Einrichtung nach Anspruch 7 oder 8,
**dadurch gekennzeichnet ,**
**daß** die Konsole (14) eine an die Dicke (t) der Träger-Metallplatte (18) angepaßte axiale Abmessung (k) aufweist.

10. Einrichtung nach einem der Ansprüche 1 bis 9,
**dadurch gekennzeichnet ,**
**daß** die Dämpfungslage (26) aus einem zelligen Polyurethan-Elastomer (PUR) besteht.

## Claims

1. A device for supporting a circuit board (28), including functional components (30), on a carrier (16) of a projectile (10),
**characterized in that**
the carrier (16) includes a metal plate (18) which is fixed in the projectile (10) so as to span its cross-section; **in that** the circuit board (28) is made of a carbon-fibre-reinforced plastic, an elastic damping layer (26) being disposed between the circuit board (28) and the carrier (16); and **in that** the circumferential edges of the circuit board (28) and of the damping layer (26) are at a distance from the inner wall of the projectile (10).

2. A device according to Claim 1,
**characterized in that**
the metal carrier plate (18) is made with a through hole (22).

3. A device according to Claim 1 or 2,
**characterized in that**
the metal carrier plate (18) has a thickness (t) which is several times greater than the thickness (p and d) of the circuit board (28) and damping layer (26).

4. A device according to Claim 3,
**characterized in that**
the damping layer (26) and the circuit board (28) have thicknesses (d, p) which are at least approximately the same.

5. A device according to Claim 3 or 4,
**characterized in that**
the circuit board (28) and the damping layer (26) are made with holes (34, 32) which are located over the through hole (22) in the metal carrier plate (18).

6. A device according to Claim 5,
**characterized in that**
the holes (34, 32) in the circuit board (28) and in the damping layer (26), and the through hole (22) in the metal carrier plate (18) are made so as to be at least approximately congruent.

7. A device according to one of Claims 1 to 5,
**characterized in that**
the metal carrier plate (18) is fixed to a bracket (14) which projects radially into the projectile (10).

8. A device according to Claim 7,
**characterized in that**
the metal carrier plate (18) is screwed to gether with the bracket (14) in axial direction of the projectile (10).

9. A device according to Claim 7 or 8,
**characterized in that**
the bracket (14) has an axial dimension which is adapted to the thickness (t) of the metal carrier plate (18).

10. A device according to one of Claims 1 to 9,
**characterized in that**
the damping layer (26) consists of a cellular polyurethane elastomer (PUR).

## Revendications

1. Dispositif destiné à soutenir une plaquette à circuits imprimés (28) avec des composants fonctionnels (30), contre un support (16) d'un projectile (10), **caractérisé en ce que** le support 16) comporte une plaque métallique (18) qui est fixée dans le projectile (10), en franchissant sa section, **en ce que** la plaquette à circuits imprimées (28) est constituée d'une matière plastique renforcée aux fibres de carbone, une couche d'amortissement élastique (26) étant prévue entre la plaquette à circuits imprimés (28) et le support (16) et **en ce que** la plaquette à circuits imprimés (28) et la couche d'amortissement (26) sont espacées, par leurs bords périphériques, de la paroi intérieure du projectile (10).

2. Dispositif selon la revendication , **caractérisé en ce que** la plaque métallique (18) du support présente un trou traversant (22).

3. Dispositif selon la revendication 1 ou 2, **caractérisé en ce que** la plaque métallique (18) du support présente une épaisseur (t) qui est plusieurs fois supérieure à l'épaisseur (p et d) de la plaquette à circuits imprimés (28) et de la couche d'amortissement (26).

4. Dispositif selon la revendication 3, **caractérisé en ce que** la couche d'amortissement (26) et la plaquette à circuits imprimés (28) présente des épaisseurs (d, p) au moins approximativement adaptées l'une à l'autre.

5. Dispositif selon la revendication 3 ou 4, **caractérisé en ce que** la plaquette à circuits imprimés (28) et la couche d'amortissement (26) comportent des trous (34, 32) qui recouvrent le trou traversant (22) de la plaque métallique (18) du support.

6. Dispositif selon la revendication 5, **caractérisé en ce que** les trous (34, 32) de la platine à circuits imprimés (28) et de la couche d'amortissement (26), ainsi que le trou traversant (22) de la plaque métallique (18) du support sont au moins approximativement coïncidents.

7. Dispositif selon l'une des revendications 1 à 5, **caractérisé en ce que** la plaque métallique (18) du support est fixée à une console (14) qui s'engage radialement dans le projectile (10).

8. Dispositif selon la revendication 7, **caractérisé en ce que** la plaque métallique (18) du support est vissée avec la console (14) dans la direction axiale du projectile (10).

9. Dispositif selon la revendication 7 ou 8, **caractérisé en ce que** la console (14) présente une dimension axiale (k) adaptée à l'épaisseur (t) de la plaque métallique ( 18) du support.

10. Dispositif selon l'une des revendications 1 à 9, **caractérisé en ce que** la couche d'amortissement (26) est constituée d'un élastomère de polyuréthanne cellulaire (PUR).
